# EUROPEAN PATENT APPLICATION

(11) **EP 4 668 303 A1**
(43) Date of publication of application: **24.12.2025**
(21) Application number: 24183083.5
(22) Date of filing: 19.06.2024
(51) Int. Cl.: H01G 9/00, H01G 9/028, H01G 9/055, H01G 9/15, C09D 165/00, H01G 9/04

(54) **CONDUCTIVE POLYMER DISPERSIONS FOR IMPROVED STABILITY PERFORMANCE OF CAPACITORS**

(71) Applicant: Heraeus Epurio GmbH, 63450 Hanau (DE)
(72) Inventor: Ishikawa, Akio, Tokyo 112-0012 (JP); Miyazaki, Yayoi, Tokyo 112-0012 (JP); Merker, Udo, 51368 Leverkusen (DE); Hayashi, Eri, Tokyo 112-0012 (JP)
(74) Representative: Herzog IP Patentanwalts GmbH

(57) **Abstract**

The present invention relates to a process for the preparation of a layered body (100), comprising the process steps:
**A)** provision of a substrate (101);
**B)** application of a liquid composition onto at least a part of a surface of this substrate (101),
wherein the liquid composition comprises
**i)** a conductive polymer;
**ii)** a dispersant in which the conductive polymer is dispersed;
**iii)** an aromatic nitro compound;

wherein the liquid composition comprises the aromatic nitro compound **iii)** in an amount in the range from 0.025 to 0.9 wt.-%, based on the weight of the liquid composition.

**C)** at least partial removal of the dispersant ii) to obtain a layered body (100) comprising an electrically conductive layer (102) coated onto at least a part of the surface of the substrate (101).

The invention also relates to a layered body, to an electronic device comprising a layered body, to a liquid composition and to the use of a liquid composition for the preparation of a layered body in an electronic device.

## Description

### FIELD OF THE INVENTION

The present invention relates to a process for the preparation of a layered body, to a layered body, to an electronic device comprising a layered body, to a liquid composition and to the use of a liquid composition for the preparation of a layered body in an electronic device.

### BACKGROUND OF THE INVENTION

A standard electrolytic capacitor generally consists of a porous metal electrode, an oxide layer disposed on the metallic surface, an electrically conductive material, generally a solid, which is introduced into the porous structure, an external electrode (contact), such as a silver layer, and other electrical contacts and an encapsulation. One frequently used electrolytic capacitor is the tantalum electrolytic capacitor, of which the anode electrode is made from the valve metal tantalum, on which a uniform, dielectric layer of tantalum pentoxide has been produced through anodic oxidation (also referred to as *"forming"*)*.* A liquid or solid electrolyte forms the cathode of the capacitor. Aluminium capacitors, of which the anode electrode is made from the valve metal aluminium, on which a uniform, electrically insulating aluminium oxide layer is produced as a dielectric by means of anodic oxidation, are also frequently used. Here also, a liquid electrolyte or a solid electrolyte form the cathode of the capacitor. The aluminium capacitors are generally embodied as wound capacitors or stack-type capacitors.

In view of their high electrical conductivity, π-conjugated polymers are particularly suitable as solid electrolytes in the capacitors described above. π-conjugated polymers are also referred to as conductive polymers or as synthetic metals. They are gaining increasing commercial significance because, by comparison with metals, polymers have advantages regarding processing, weight and the selective adjustment of properties through chemical modification. Examples of known π-conjugated polymers include polypyrroles, polythiophenes, polyanilines, polyacetylenes, polyphenylenes and poly(p-phenylene-vinylenes), wherein poly(3,4-ethylene-dioxythiophene) (PEDOT) is a particularly important polythiophene which is used technically, because it has a very high conductivity in its oxidised form.

The life-time of electrolytic capacitors is limited by the degradation of the electrical parameters like the increase of the equivalent series resistance (ESR) or the dissipation factor (DF). Life-time issues are pronounced the closer the applied voltage of the capacitor is to the maximum voltage used for the forming of the dielectric during anodic oxidation.

The present invention was based on the object of overcoming the disadvantages resulting from the prior art in connection with capacitors, preferably in connection with electrolytic capacitors, more preferably in connection with capacitors known from the prior art that comprise a solid electrolyte layer based on π-conjugated polymers such polythiophenes, even more preferably in connection with capacitors known from the prior art that comprise a solid electrolyte layer based on PEDOT/PSS, PEDOT-S or mixtures of such polythiophenes.

In particular, the present invention was based on the object of providing such capacitors, wherein the physical parameters, such as the dissipation factor and the ESR, change as little as possible. Such a stability should particularly also be given if the capacitors are operated at an elevated temperature in the order of 100°C or even higher.

It was also an object of the present invention to provide a liquid composition that is suitable for the formation of a solid electrolyte layer in a capacitor that is characterized by the above-described stability, in particular by the above-described stability in terms of the dissipation factor and the ESR Such a stability should again particularly also be given if the capacitors are operated at an elevated temperature in the order of 100°C or even higher.

### SUMMARY OF THE INVENTION

A contribution to at least partly solving at least one, preferably more than one, of the above objects is made by the independent claims. The dependent claims provide preferred embodiments which contribute to at least partly solving at least one of the objects.
|**1a**| A contribution to solving at least one of the objects according to the invention is made by a 1^{st} embodiment of a process for the preparation of a layered body, comprising the process steps:
   **A)** provision of a substrate;
   **B)** application of a liquid composition onto at least a part of a surface of this substrate, wherein the liquid composition comprises
      **i)** a conductive polymer;
      **ii)** a dispersant in which the conductive polymer is dispersed;
      **iii)** an aromatic nitro compound;
         wherein the liquid composition comprises the aromatic nitro compound iii) in an amount in the range from 0.025 to 0.9 wt.-%, preferably in the range from 0.1 to 0.9 wt.-%, more preferably in the range from 0.1 to 0.8 wt.-%, even more preferably in the range from 0.1 to 0.6 wt.-%, even more preferably in the range from 0.2 to 0.5 wt.-%, even more preferably in the range from 0.2 to 0.4 wt.-%, in each case based on the weight of the liquid composition;
   **C)** at least partial removal of the dispersant **ii)** to obtain a layered body comprising an electrically conductive layer coated onto at least a part of the surface of the substrate.
      The term "*dispersed*" as used in context with the present invention general refers to any liquid composition in which a conductive polymer, such as a polythiophene, is somehow distributed in a homogeneous phase that is formed by the liquid dispersant **ii)** (dispersant **ii)** thus forms the liquid phase of the liquid composition). It should be noted that transitions between a "*dispersion*" and a "*solution*" can be fluid. For that reason, no distinction is made hereafter between the terms "*dispersed*" and "*dissolved*"*.* Likewise, no distinction is made between "*dispersion*" and "*solution*" or between "*dispersant*" and "*solvent*"*.* Rather these terms are used synonymously hereafter.
|**2a**| According to a preferred embodiment of the process according to the invention, the electrically conductive layer comprises the aromatic nitro compound iii) in an amount in the range from 5 to 80 wt.-%, preferably in the range from 10 to 65 wt.-%, more preferably in the range from 10 to 50 wt.-%, even more preferably in the range from 10 to 40 wt.-% and more preferably in the range from 10 to 30 wt.-%, in each case based on the total weight of the electrically conductive layer. This preferred embodiment is a 2^{nd} embodiment of the process according to the present invention, that preferably depends on the 1^{st} embodiment.
|**3a**| According to a further preferred embodiment of the process according to the invention, the layered body is part of an electrolyte capacitor, wherein the substrate is a porous electrode body made of an electrode material, wherein a dielectric layer at least partially covers a surface of this electrode material and wherein the electrically conductive layer is a solid electrolyte layer, the dielectric layer being arranged between the electrode material and the solid electrolyte layer. This preferred embodiment is a 3^{rd} embodiment of the process according to the present invention, that preferably depends on the 1^{st} or the 2^{nd} embodiment. The term "*the dielectric layer being arranged between the electrode material and the solid electrolyte layer*" as used herein does not necessarily require any direct contact between, for example, the dielectric layer and the solid electrolyte layer that has been prepared using the liquid composition comprising components **i), ii)** and **iii).** It is, for example, also possible that between the dielectric layer and the solid electrolyte layer one or more intermediate layers are provided, such as conductive polymer layers prepared by means of a composition different from the liquid composition comprising components **i), ii)** and **iii),** or adhesive layers.
|**4a**| According to a further preferred embodiment of the process according to the invention, the process comprises the steps of:
   **A)** provision of a porous electrode body made of an electrode material, wherein a dielectric layer at least partially covers a surface of this electrode material;
   **B)** introduction of the liquid composition into at least a part of the porous electrode body provided in process step **A);**
   **C)** at least partial removal of the dispersant ii) for the formation of a solid electrolyte layer.
   This preferred embodiment is a 4^{th} embodiment of the process according to the present invention, that preferably depends on the 3^{rd} embodiment.
   As outlined in connection with embodiment |**3a**|, no direct contact is required between, for example, the dielectric layer and the solid electrolyte layer that has been prepared by the liquid composition comprising components **i), ii)** and **iii).** Thus, the process may comprise additional process steps between step **A)** and step **B),** such as a process step in which one or more intermediate layers are coated onto the dielectric layer before forming the solid electrolyte layer using the liquid composition comprising components **i), ii)** and **iii).**
**|5a|** According to a further preferred embodiment of the process according to the invention, the conductive polymer **i)** comprises a polythiophene, preferably a foreign-doped polythiophene, such as a cationic polythiophene that is present in the form of a polythiophene/polyanion-complex, more preferably in the form of a PEDOT/PSS-complex, a self-doped polythiophene, such as poly(4-[(2,3-dihydrothieno-[3,4-b]-[1,4]dioxin-2-yl)methoxy]-propane-1 -sulfonic acid), poly(4-[(2,3-dihydro-thieno-[3,4-b][1,4]dioxin-2-yl)methoxy]butane-1-sulfonic acid) (PEDOT-S) or poly-(4-[(2,3-dihydrothieno[3,4-b][1,4]dioxin-2-yl)methoxy]butane-2-sulfonic acid), or a mixture thereof. This preferred embodiment is a 5^{th} embodiment of the process according to the present invention, that preferably depends on any of the 1^{st} to the 4^{th} embodiment.
|**6a**| According to a further preferred embodiment of the process according to the invention, the conductive polymer **i)** comprises a self-doped polythiophene, preferably a self-doped polythiophene selected from the group consisting of poly(4-[(2,3-dihydrothieno-[3,4-b]-[1 ,4]dioxin-2-yl)methoxy]-propane-1-sulfonic acid), poly(4-[(2,3-dihydro-thieno-[3,4-b][1,4]dioxin-2-yl)methoxy]butane-1-sulfonic acid) (PEDOT-S) or poly-(4-[(2,3-dihydrothieno[3,4-b][1,4]dioxin-2-yl)methoxy]butane-2-sulfonic acid), or a mixture thereof. This preferred embodiment is a 6^{th} embodiment of the process according to the present invention, that preferably depends on the 5^{th} embodiment.
|**7a**| According to a further preferred embodiment of the process according to the invention, the polythiophene is a foreign-doped polythiophene that is present in the form of particles of a complex comprising the polythiophene and a polyanion, preferably a PEDOT/PSS-complex. This preferred embodiment is a 7^{th} embodiment of the process according to the present invention, that preferably depends on the 5^{th} embodiment.
|**8a**| According to a further preferred embodiment of the process according to the invention, the weight ratio aromatic nitro compound **iii)** to the total weight of polythiophene and a polyanion in the electrically conductive layer is in the range from 0.1 to 0.5, preferably in the range from 0.1 to 0.45, more preferably in the range from 0.1 to 0.4, even more preferably in the range from 0.1 to 0.3 and even more preferably in the range from 0.1 to 0.2. This preferred embodiment is an 8^{th} embodiment of the process according to the present invention, that preferably depends on the 7^{th} embodiment.
|**9a**| According to a further preferred embodiment of the process according to the invention, the conductive polymer **i)** comprises a polythiophene that is present in the form of particles of a complex comprising the polythiophene and a polyanion, preferably in the form of particles comprising PEDOT/PSS, wherein liquid composition comprises the polyanion and the polythiophene in a weight ratio polyanion : polythiophene in the range from of 0.5 : 1 to 30 : 1, preferably in the range from of 0.8 : 1 to 15 : 1, more preferably in the range from 1 : 1 to 10 : 1, even more preferably in the range from 1.2 : 1 to 8 : 1 and most preferably in the range from 1.4 : 1 to 4 : 1. The weight of the polythiophene in this context corresponds to the weighed amount of the thiophene monomers used for the preparation of the polythiophene, on the assumption that a complete conversion takes place during the polymerisation. This preferred embodiment is a 9^{th} embodiment of the process according to the present invention, that preferably depends on any of the 1^{st} to the 5^{th}, 7^{th} and 8^{th} embodiment.
|**10a**| According to a further preferred embodiment of the process according to the invention, the conductive polymer **i)** comprises a polythiophene that is present in the form of particles of a complex comprising the polythiophene and a polyanion, preferably in the form of particles comprising PEDOT/PSS, wherein the weight average diameter (**d₅₀**) as determined by ultra-centrifuge measurement of these particles is in the range from 1 nm to 100 nm, more preferably in the range from 2 nm to 50 nm, even more preferably in the range from 3 nm to 40 nm and most preferably in the range from 4 nm to 30 nm. This preferred embodiment is a 10^{th} embodiment of the process according to the present invention, that preferably depends on any of the 1^{st} to the 5^{th} and the 7^{th} to the 9^{th} embodiment.
|**11a**| According to a further preferred embodiment of the process according to the invention, the conductive polymer **i)** comprises a polythiophene that is present in the form of particles of a complex comprising the polythiophene and a polyanion, preferably in the form of particles comprising PEDOT/PSS, wherein the liquid composition has a **d₉₀**-value of the diameter distribution of these particles as determined by ultra-centrifuge measurement of less than 150 nm, preferably less than 100 nm, more preferably less than 80 nm and most preferably less than 50 nm. This preferred embodiment is an 11^{th} embodiment of the process according to the present invention, that preferably depends on any of the 1^{st} to the 5^{th} and the 7^{th} to the 10^{th} embodiment.
|**12a**| According to a further preferred embodiment of the process according to the invention, the conductive polymer **i)** comprises a polythiophene that is present in the form of particles of a complex comprising the polythiophene and a polyanion, preferably in the form of particles comprising PEDOT/PSS, wherein the liquid composition has a **d₁₀**-value of the diameter distribution of these particles as determined by ultra-centrifuge measurement of greater than 1 nm, preferably greater than 2 nm, more preferably greater than 3 nm and most preferably greater than 4 nm. This preferred embodiment is an 12^{th} embodiment of the process according to the present invention, that preferably depends on any of the 1^{st} to the 5^{th} and the 7^{th} to the 11^{th} embodiment.
|**13a**| According to a further preferred embodiment of the process according to the invention, the liquid composition has a pH-value (determined at 25°C) from 1 to 14, a pH value from 1 to 8 is preferred. For corrosion-sensitive dielectrics, such as aluminium oxides or niobium oxides, liquid compositions in the range from 2.5 to 8.0, preferably in the range from 2.5 to 7 and more preferably in the range from 3 to 6. This preferred embodiment is a 13^{h} embodiment of the process according to the present invention, that preferably depends on any of the 1^{st} to the 12^{th} embodiment.
|**14a**| According to a further preferred embodiment of the process according to the invention, the conductive polymer **i)** comprises a polythiophene that is present in the form of particles of a complex comprising the polythiophene and a polyanion, preferably in the form of particles comprising PEDOT/PSS, wherein the liquid composition comprises the polythiophene and the polyanion in a total amount (*i. e*., the amount of polythiophene plus the amount of polyanion) of at least 0.8 wt.-%, preferably of at least 1.4 wt.-%, more preferably of at least 1.6 wt.-%, even more preferably of at least 1.7 wt.-% and most preferably of at least 1.8 wt.-%, in each case based on the total weight of the liquid composition. This preferred embodiment is a 14^{th} embodiment of the process according to the present invention, that preferably depends on any of the 1^{st} to the 5^{th} and the 7^{th} to the 13^{th} embodiment.
|**15a**| According to a further preferred embodiment of the process according to the invention, the liquid composition further comprises
   **iv)** at least one additive, wherein the at least one additive is an additive selected from the group consisting of a binder, a pH-regulator, a crosslinker, an adhesion promoter, a conductivity improver, a surfactant, a stabilizer and a combination of at least two of these additives.
   This preferred embodiment is a 15^{th} embodiment of the process according to the present invention, that preferably depends on any of the 1^{st} to the 14^{th} embodiment.
|**16a**| According to a further preferred embodiment of the process according to the invention, the liquid composition has a solids content of at least 0.8 wt.-%, preferably of at least 1.4 wt.-%, more preferably of at least 1.6 wt.-%, even more preferably of at least 1.8 wt.-% and most preferably of at least 2.0 wt.-%, in each case based on the total weight of the liquid composition. This preferred embodiment is a 16^{th} embodiment of the process according to the present invention, that preferably depends on any of the 1^{st} to the 15^{th} embodiment.
|**17a**| According to a further preferred embodiment of the process according to the invention, the liquid composition has a viscosity (measured with a rheometer at 20°C and a shear rate of 100 s ¹) in the range from 0.1 to 200 mPa×s, preferably in the range from 1 to 100 mPa×s, more preferably in the range from 5 to 70 mPa×s and most preferably in the range from 10 to 50 mPa×s. This preferred embodiment is a 17^{th} embodiment of the process according to the present invention, that preferably depends on any of the 1^{st} to the 16^{th} embodiment.
|**18a**| According to a further preferred embodiment of the process according to the invention, the dispersant **ii)** comprises water. Preferably, dispersant **ii)** comprises water in an amount of at least 50 wt.-%, more preferably at least 65 wt.-%, even more preferably at least 70 wt.-% and most preferably at least 80 wt.-%, in each case based on the total weight of the liquid composition. This preferred embodiment is a 18^{th} embodiment of the process according to the present invention, that preferably depends on any of the 1^{st} to the 17^{th} embodiment.
|**19a**| According to a further preferred embodiment of the process according to the invention, the aromatic nitro compound **iii)** has a dry residue, as determined by the test method disclosed herein, of at least 1 wt.-%, preferably of at least 1.5 wt.-%, more preferably of at least 2 wt.-%, even more preferably of at least 2.5 wt.-% and even more preferably of at least 3 wt.-%. This preferred embodiment is a 19^{th} embodiment of the process according to the present invention, that preferably depends on any of the 1^{st} to the 18^{th} embodiment.
|**20a**| According to a further preferred embodiment of the process according to the invention, the the aromatic nitro compound **iii)** has the structural formula **(A)** 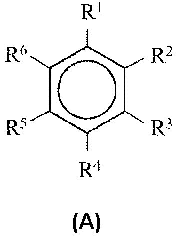 wherein at least one of residues **R¹-R⁶** is a group -NO₂. In this context each residue **R¹-R⁶** can, for example, be selected from the group consisting of -H, -CH₃, -COOH, -SO₃H, -SO₃Na, -CH₂-PO(OC₂H₅)₂, -OCH₃, -CH₂OH, -OH, -CH₂-O-COCH₃ (with the proviso at least one of residues **R¹-R⁶** is a group -NO₂). According to a particularly preferred embodiment of the aromatic nitro compound iii), at least one of residues **R¹-R⁶** is a group -NO₂ and at least one of residues **R¹-R⁶** is a group -CH₂OH. This preferred embodiment is a 20^{th} embodiment of the process according to the present invention, that preferably depends on any of the 1^{st} to the 19^{th} embodiment.
|**21a**| According to a further preferred embodiment of the process according to the invention, the aromatic nitro compound **iii)** is selected from the group consisting of 2,4,6-Trinitrophenol, 2-(2,4-Dinitrobenzyl)pyridine, 3,5-Dinitrobenzyl alcohol, 4,5-Dimethoxy-2-nitrobenzyl alcohol, 4-Hydroxy-3-nitro-benzenemethanol, 1-(4-Nitrobenzyl)-1,2,4-triazole, 2-Hydroxy-5-nitrobenzyl alcohol, Diethyl(4-nitrobenzyl)phosphonate or a combination of at least two of these aromatic nitro compounds. This preferred embodiment is a 21^{st} embodiment of the process according to the present invention, that preferably depends on any of the 1^{st} to the 20^{th} embodiment.
|**1b**| A contribution to solving at least one of the objects according to the invention is also made by a layered body obtainable by the process according to the present invention, preferably by a process according to the present invention as defined in any of its 1^{st} to the 21^{st} embodiment.
|**1c**| A contribution to solving at least one of the objects according to the invention is also made by a layered body comprising a substrate and an electrically conductive layer coated onto at least a part of a surface of the substrate, wherein the electrically conductive layer comprises
   **i)** a conductive polymer;
   **iii)** an aromatic nitro compound; wherein the electrically conductive layer comprises the aromatic nitro compound iii) in an amount in the range from 5 to 80 wt.-%, preferably in the range from 10 to 65 wt.-%, more preferably in the range from 10 to 50 wt.-%, even more preferably in the range from 10 to 40 wt.-% and more preferably in the range from 10 to 30 wt.-%, in each case based on the total weight of the electrically conductive layer.
|**2c**| According to a preferred embodiment of the layered body according to the invention, the layered body is part of an electrolyte capacitor, wherein the substrate is a porous electrode body made of an electrode material, wherein a dielectric layer at least partially covers a surface of this electrode material and wherein the electrically conductive layer is a solid electrolyte layer, the dielectric layer being arranged between the electrode material and the solid electrolyte layer. This preferred embodiment is a 2^{nd} embodiment of the layered body according to the present invention, that preferably depends on the 1^{st} embodiment.
   The term "*the dielectric layer being arranged between the electrode material and the solid electrolyte layer*" as used herein again does not necessarily require any direct contact between, for example, the dielectric layer and the solid electrolyte layer that comprises components i) and **iii).** It is, for example, also possible that between the dielectric layer and the solid electrolyte layer one or more intermediate layers are provided, such as conductive polymer others than those comprising components **i)** and **iii),** or adhesive layers.
|**3c**| According to a further preferred embodiment of the layered body according to the invention, the layered body is an aluminum capacitor or a tantalum capacitor. This preferred embodiment is a 3^{rd} embodiment of the layered body according to the present invention, that preferably depends on the 1^{st} or the 2^{nd} embodiment.
|**4c**| According to a further preferred embodiment of the layered body according to the invention, the conductive polymer **i)** comprises a polythiophene, preferably a foreign-doped polythiophene, such as a cationic polythiophene that is present in the form of a polythiophene/polyanion-complex, more preferably in the form of a PEDOT/PSS-complex, a self-doped polythiophene, such as poly(4-[(2,3-dihydrothieno-[3,4-b]-[1,4]dioxin-2-yl)methoxy]-propane-1-sulfonic acid), poly(4-[(2,3-dihydro-thieno-[3,4-b][1,4]dioxin-2-yl)methoxy]butane-1-sulfonic acid) (PEDOT-S) or poly-(4-[(2,3-dihydrothieno[3,4-b][1,4]dioxin-2-yl)methoxy]butane-2-sulfonic acid), or a mixture thereof. This preferred embodiment is a 4^{th} embodiment of the layered body according to the present invention, that preferably depends on any of the 1^{st} to the 3^{rd} embodiment.
|**5c**| According to a further preferred embodiment of the layered body according to the invention, the conductive polymer **i)** comprises a self-doped polythiophene, preferably a self-doped polythiophene selected from the group consisting of poly(4-[(2,3-dihydrothieno-[3,4-b]-[1,4]dioxin-2-yl)methoxy]-propane-1-sulfonic acid), poly(4-[(2,3-dihydro-thieno-[3,4-b][1,4]dioxin-2-yl)me-thoxy]butane-1-sulfonic acid) (PEDOT-S) or poly-(4-[(2,3-dihydrothieno[3,4-b][1,4]dioxin-2-yl)methoxy]butane-2-sulfonic acid), or a mixture thereof. This preferred embodiment is a 5^{th} embodiment of the layered body according to the present invention, that preferably depends on the 4^{th} embodiment.
|**6c**| According to a further preferred embodiment of the layered body according to the invention, the polythiophene is a foreign-doped polythiophene that is present in the form of particles of a complex comprising the polythiophene and a polyanion, preferably a PEDOT/PSS-complex. This preferred embodiment is a 6^{th} embodiment of the layered body according to the present invention, that preferably depends on the 4^{th} embodiment.
|**7c**| According to a further preferred embodiment of the layered body according to the invention, the weight ratio aromatic nitro compound **iii)** to the total weight of polythiophene and a polyanion in the electrically conductive layer is in the range from 0.1 to 0.5, preferably in the range from 0.1 to 0.45, more preferably in the range from 0.1 to 0.4, even more preferably in the range from 0.1 to 0.3 and even more preferably in the range from 0.1 to 0.2. This preferred embodiment is a 7^{th} embodiment of the layered body according to the present invention, that preferably depends on the 6^{th} embodiment.
|**8c**| According to a further preferred embodiment of the layered body according to the invention, the aromatic nitro compound **iii)** has a dry residue, as determined by the test method disclosed herein, of at least 1 wt.-%, preferably of at least 1.5 wt.-%, more preferably of at least 2 wt.-%, even more preferably of at least 2.5 wt.-% and even more preferably of at least 3 wt.-%. This preferred embodiment is an 8^{th} embodiment of the layered body according to the present invention, that preferably depends on any of the 1^{st} to the 7^{th} embodiment.
|**9c**| According to a further preferred embodiment of the layered body according to the invention, the the aromatic nitro compound **iii)** has the structural formula **(A)** 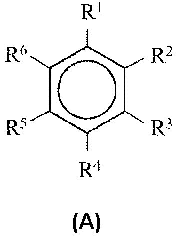 wherein at least one of residues **R¹-R⁶** is a group -NO₂. In this context each residue **R¹-R⁶** can, for example, be selected from the group consisting of -H, -CH₃, -COOH, -SO₃H, -SO₃Na, -CH₂-PO(OC₂H₅)₂, -OCH₃, -CH₂OH, -OH, -CH₂-O-COCH₃ (with the proviso at least one of residues **R¹-R⁶** is a group -NO₂). According to a particularly preferred embodiment of the aromatic nitro compound iii), at least one of residues **R¹-R⁶** is a group -NO₂ and at least one of residues **R¹-R⁶** is a group -CH₂OH. This preferred embodiment is a 9^{th} embodiment of the layered body according to the present invention, that preferably depends on any of the 1^{st} to the 8^{th} embodiment.
|**10c**| According to a further preferred embodiment of the layered body according to the invention, the aromatic nitro compound **iii)** is selected from the group consisting of 2,4,6-Trinitrophenol, 2-(2,4-Dinitrobenzyl)pyridine, 3,5-Dinitrobenzyl alcohol, 4,5-Dimethoxy-2-nitrobenzyl alcohol, 4-Hydroxy-3-nitro-benzenemethanol, 1-(4-Nitrobenzyl)-1,2,4-triazole, 2-Hydroxy-5-nitrobenzyl alcohol, Diethyl(4-nitrobenzyl)phosphonate or a combination of at least two of these aromatic nitro compounds. This preferred embodiment is a 10^{th} embodiment of the layered body according to the present invention, that preferably depends on any of the 1^{st} to the 9^{th} embodiment.
|**1d**| A contribution to solving at least one of the objects according to the invention is also made by an electronic device comprising a layered body obtainable by the process according to the present invention, preferably by a process according to the present invention as defined in any of its 1^{st} to the 21^{th} embodiment, or a layered body according to the present invention, preferably by a layered body according to the present invention as defined in any of its 1^{st} to the 10^{th} embodiment. Preferably, the electronic device is a solid electrolyte capacitor, more preferably an aluminum capacitor or a tantalum capacitor.
|**1e**| A contribution to solving at least one of the objects according to the invention is also made by a liquid composition comprising
   **i)** a conductive polymer;
   **ii)** a dispersant in which the conductive polymer is dispersed;
   **iii)** an aromatic nitro compound;
   wherein the liquid composition comprises the aromatic nitro compound **iii)** in an amount in the range from 0.025 to 0.9 wt.-%, preferably in the range from 0.1 to 0.9 wt.-%, more preferably in the range from 0.1 to 0.8 wt.-%, even more preferably in the range from 0.1 to 0.6 wt.-%, even more preferably in the range from 0.2 to 0.5 wt.-%, even more preferably in the range from 0.2 to 0.4 wt.-%, in each case based on the weight of the liquid composition.
|**2e**| According to a preferred embodiment of the liquid composition according to the invention, the conductive polymer **i)** comprises a polythiophene, preferably a foreign-doped polythiophene, such as a cationic polythiophene that is present in the form of a polythiophene/polyanion-complex, more preferably in the form of a PEDOT/PSS-complex, a self-doped polythiophene, such as poly(4-[(2,3-dihydrothieno-[3,4-b]-[1,4]dioxin-2-yl)methoxy]-propane-1-sulfonic acid), poly(4-[(2,3-dihydro-thieno-[3,4-b][1,4]dioxin-2-yl)methoxy]butane-1-sulfonic acid) (PEDOT-S) or poly-(4-[(2,3-dihydrothieno[3,4-b][1,4]dioxin-2-yl)methoxy]butane-2-sulfonic acid), or a mixture thereof. This preferred embodiment is a 2^{nd} embodiment of the liquid composition according to the present invention, that preferably depends on the 1^{st} embodiment.
|**3e**| According to a further preferred embodiment of the liquid composition according to the invention, the conductive polymer **i)** comprises a self-doped polythiophene, preferably a self-doped polythiophene selected from the group consisting of poly(4-[(2,3-dihydrothieno-[3,4-b]-[1,4]dioxin-2-yl)methoxy]-propane-1-sulfonic acid), poly(4-[(2,3-dihydro-thieno-[3,4-b][1,4]dioxin-2-yl)me-thoxy]butane-1-sulfonic acid) (PEDOT-S) or poly-(4-[(2,3-dihydrothieno[3,4-b][1,4]dioxin-2-yl)methoxy]butane-2-sulfonic acid), or a mixture thereof. This preferred embodiment is a 3^{rd} embodiment of the liquid composition according to the present invention, that preferably depends on the 2^{nd} embodiment.
|**4e|** According to a further preferred embodiment of the liquid composition according to the invention, the polythiophene is a foreign-doped polythiophene that is present in the form of particles of a complex comprising the polythiophene and a polyanion, preferably a PEDOT/PSS-complex. This preferred embodiment is a 4^{th} embodiment of the liquid composition according to the present invention, that preferably depends on the 2^{nd} embodiment.
|**5e**| According to a further preferred embodiment of the liquid composition according to the invention, the weight ratio aromatic nitro compound **iii)** to the total weight of polythiophene and a polyanion in the liquid composition is in the range from 0.1 to 0.5, preferably in the range from 0.1 to 0.45, more preferably in the range from 0.1 to 0.4, even more preferably in the range from 0.1 to 0.3 and even more preferably in the range from 0.1 to 0.2. This preferred embodiment is a 5^{th} embodiment of the liquid composition according to the present invention, that preferably depends on the 4^{th} embodiment.
|**6e**| According to a further preferred embodiment of the liquid composition according to the invention, the conductive polymer **i)** comprises a polythiophene that is present in the form of particles of a complex comprising the polythiophene and a polyanion, preferably in the form of particles comprising PEDOT/PSS, wherein liquid composition comprises the polyanion and the polythiophene in a weight ratio polyanion : polythiophene in the range from of 0.5 : 1 to 30 : 1, preferably in the range from of 0.8 : 1 to 15 : 1, more preferably in the range from 1 : 1 to 10 : 1, even more preferably in the range from 1.2 : 1 to 8 : 1 and most preferably in the range from 1.4 : 1 to 4 : 1. The weight of the polythiophene in this context corresponds to the weighed amount of the thiophene monomers used for the preparation of the polythiophene, on the assumption that a complete conversion takes place during the polymerisation. This preferred embodiment is a 6^{th} embodiment of the liquid composition according to the present invention, that preferably depends on any of the 1^{st}, the 2^{nd}, the 4^{th} or the 5^{th} embodiment.
|**7e**| According to a further preferred embodiment of the liquid composition according to the invention, the conductive polymer **i)** comprises a polythiophene that is present in the form of particles of a complex comprising the polythiophene and a polyanion, preferably in the form of particles comprising PEDOT/PSS, wherein the weight average diameter (**d₅₀**) as determined by ultra-centrifuge measurement of these particles is in the range from 1 nm to 100 nm, more preferably in the range from 2 nm to 50 nm, even more preferably in the range from 3 nm to 40 nm and most preferably in the range from 4 nm to 30 nm. This preferred embodiment is a 9^{th} embodiment of the liquid composition according to the present invention, that preferably depends on any of the 1^{st}, the 2^{nd} and the 4^{th} to the 6^{th} embodiment.
|**8e**| According to a further preferred embodiment of the liquid composition according to the invention, the conductive polymer **i)** comprises a polythiophene that is present in the form of particles of a complex comprising the polythiophene and a polyanion, preferably in the form of particles comprising PEDOT/PSS, wherein the liquid composition has a **d₉₀**-value of the diameter distribution of these particles as determined by ultra-centrifuge measurement of less than 150 nm, preferably less than 100 nm, more preferably less than 80 nm and most preferably less than 50 nm. This preferred embodiment is an 8^{th} embodiment of the liquid composition according to the present invention, that preferably depends on any of the 1^{st}, the 2^{nd} and the 4^{th} to the 7^{th} embodiment.
|**9e**| According to a further preferred embodiment of the liquid composition according to the invention, the conductive polymer **i)** comprises a polythiophene that is present in the form of particles of a complex comprising the polythiophene and a polyanion, preferably in the form of particles comprising PEDOT/PSS, wherein the liquid composition has a **d₁₀**-value of the diameter distribution of these particles as determined by ultra-centrifuge measurement of greater than 1 nm, preferably greater than 2 nm, more preferably greater than 3 nm and most preferably greater than 4 nm. This preferred embodiment is a 9^{th} embodiment of the liquid composition according to the present invention, that preferably depends on any of the 1^{st}, the 2^{nd} and the 4^{th} to the 8^{th} embodiment.
|**10e**| According to a further preferred embodiment of the liquid composition according to the invention, the liquid composition has a pH-value (determined at 25°C) from 1 to 14, a pH value from 1 to 8 is preferred. For corrosion-sensitive dielectrics, such as aluminium oxides or niobium oxides, liquid compositions in the range from 2.5 to 8.0, preferably in the range from 2.5 to 7 and more preferably in the range from 3 to 6. This preferred embodiment is a 10^{th} embodiment of the liquid composition according to the present invention, that preferably depends on any of the 1^{st} to the 9^{th} embodiment.
|**11e**| According to a further preferred embodiment of the liquid composition according to the invention, the conductive polymer **i)** comprises a polythiophene that is present in the form of particles of a complex comprising the polythiophene and a polyanion, preferably in the form of particles comprising PEDOT/PSS, wherein the liquid composition comprises the polythiophene and the polyanion in a total amount (*i. e*., the amount of polythiophene plus the amount of polyanion) of at least 0.8 wt.-%, preferably of at least 1.4 wt.-%, more preferably of at least 1.6 wt.-%, even more preferably of at least 1.7 wt.-% and most preferably of at least 1.8 wt.-%, in each case based on the total weight of the liquid composition. This preferred embodiment is an 11^{th} embodiment of the liquid composition according to the present invention, that preferably depends on any of the 1^{st}, the 2^{nd} and the 4^{th} to the 11^{th} embodiment.
|**12e**| According to a further preferred embodiment of the liquid composition according to the invention, the liquid composition further comprises
   **v)** at least one additive, wherein the at least one additive is an additive selected from the group consisting of a binder, a pH-regulator, a crosslinker, an adhesion promoter, a conductivity improver, a surfactant, a stabilizer and a combination of at least two of these additives.
   This preferred embodiment is a 12^{th} embodiment of the liquid composition according to the present invention, that preferably depends on any of the 1^{st} to the 11^{th} embodiment.
|**13e**| According to a further preferred embodiment of the liquid composition according to the invention, the liquid composition has a solids content of at least 0.8 wt.-%, preferably of at least 1.4 wt.-%, more preferably of at least 1.6 wt.-%, even more preferably of at least 1.8 wt.-% and most preferably of at least 2.0 wt.-%, in each case based on the total weight of the liquid composition. This preferred embodiment is a 13^{th} embodiment of the liquid composition according to the present invention, that preferably depends on any of the 1^{st} to the 12^{th} embodiment.
|**14e**| According to a further preferred embodiment of the liquid composition according to the invention, the liquid composition has a viscosity (measured with a rheometer at 20°C and a shear rate of 100 s⁻¹) in the range from 0.1 to 200 mPa×s, preferably in the range from 1 to 100 mPa×s, more preferably in the range from 5 to 70 mPa×s and most preferably in the range from 10 to 50 mPa×s. This preferred embodiment is a 14^{th} embodiment of the liquid composition according to the present invention, that preferably depends on any of the 1^{st} to the 13^{th} embodiment.
|**15e**| According to a further preferred embodiment of the liquid composition according to the invention, the dispersant **ii)** comprises water. Preferably, dispersant **ii)** comprises water in an amount of at least 50 wt.-%, more preferably at least 65 wt.-%, even more preferably at least 70 wt.-% and most preferably at least 80 wt.-%, in each case based on the total weight of the liquid composition. This preferred embodiment is a 15^{th} embodiment of the liquid composition according to the present invention, that preferably depends on any of the 1^{st} to the 14^{th} embodiment.
|**16e**| According to a further preferred embodiment of the liquid composition according to the invention, the aromatic nitro compound **iii)** has a dry residue, as determined by the test method disclosed herein, of at least 1 wt.-%, preferably of at least 1.5 wt.-%, more preferably of at least 2 wt.-%, even more preferably of at least 2.5 wt.-% and even more preferably of at least 3 wt.-%. This preferred embodiment is a 16^{th} embodiment of the liquid composition according to the present invention, that preferably depends on any of the 1^{st} to the 16^{th} embodiment.
|**17e**| According to a further preferred embodiment of the liquid composition according to the invention, the the aromatic nitro compound **iii)** has the structural formula **(A)** 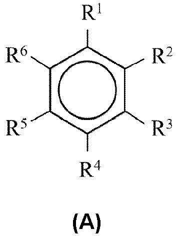 wherein at least one of residues **R¹-R⁶** is a group -NO₂. In this context each residue **R¹-R⁶** can, for example, be selected from the group consisting of -H, -CH₃, -COOH, -SO₃H, -SO₃Na, -CH₂-PO(OC₂H₅)₂, -OCH₃, -CH₂OH, -OH, -CH₂-O-COCH₃ (with the proviso at least one of residues **R¹-R⁶** is a group -NO₂). According to a particularly preferred embodiment of the aromatic nitro compound iii), at least one of residues **R¹-R⁶** is a group -NO₂ and at least one of residues **R¹-R⁶** is a group -CH₂OH. This preferred embodiment is a 17^{th} embodiment of the liquid composition according to the present invention, that preferably depends on any of the 1^{st} to the 16^{th} embodiment.
|**18e**| According to a further preferred embodiment of the liquid composition according to the invention, the aromatic nitro compound **iii)** is selected from the group consisting of 2,4,6-Trinitrophenol, 2-(2,4-Dinitrobenzyl)pyridine, 3,5-Dinitrobenzyl alcohol, 4,5-Dimethoxy-2-nitrobenzyl alcohol, 4-Hydroxy-3-nitro-benzenemethanol, 1-(4-Nitrobenzyl)-1,2,4-triazole, 2-Hydroxy-5-nitrobenzyl alcohol, Diethyl(4-nitrobenzyl)phosphonate or a combination of at least two of these aromatic nitro compounds. This preferred embodiment is an 18^{th} embodiment of the liquid composition according to the present invention, that preferably depends on any of the 1^{st} to the 17^{th} embodiment.
|**1f**| A contribution to solving at least one of the objects according to the invention is also made using the liquid composition according to the present invention, preferably of the liquid composition according to the present invention as defined in any of its 1^{st} to the 18^{th} embodiment, for the preparation of a layered body in an electronic device, preferably for the formation of a solid electrolyte layer in a capacitor, more preferably for the formation of a solid electrolyte layer in an aluminium capacitor or a tantalum capacitor.

### DETAILED DESCRIPTION

### Polythiophenes

The liquid composition according to the present invention or the liquid composition used in the process according to the present invention comprises a dispersant **ii)** and at least one conductive polymer **i)** dispersed in the dispersant, wherein the conductive polymer preferably comprises a polythiophene. Preferred polythiophenes are those with repeat units of the general formula **(I),** of the general formula **(II)**, of the general formula **(III)** or polythiophenes comprising combinations of these repeat units: 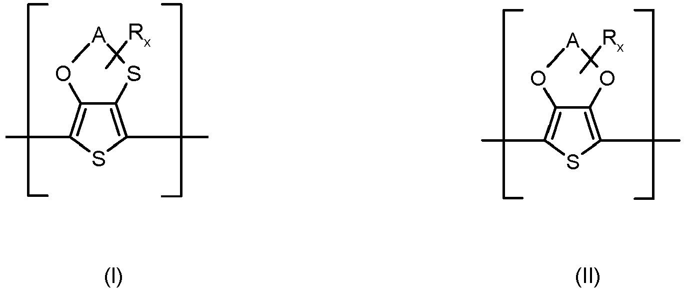 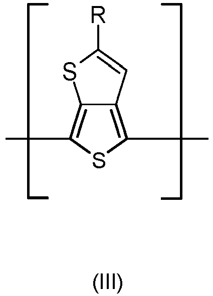 in which
- A: is an optionally substituted C₁-C₅-alkylene radical,
- R: is independently H, a linear or branched, optionally substituted C₁-C₁₈-alkyl radical, an optionally substituted C₅-C₁₂-cycloalkyl radical, an optionally substituted C₆-C₁₄-aryl radical, an optionally substituted C₇-C₁₈-aralkyl radical, an optionally substituted C₁-C₄-hydroxyalkyl radical or a hydroxyl radical,
- x: is an integer from 0 to 8 and,

in the case that a plurality of R radicals are bonded to A, they may be the same or different.

The general formulae (I) and (II) should be understood such that x substituents R may be bonded to the alkylene radical A.

Particular preference is given to polythiophenes with repeat units of the general formula (I) or (II) or repeat units of the general formulae (I) and in which A is an optionally substituted C₂-C₃-alkylene radical and x is 0 or 1. A very particularly preferred polythiophene is poly(3,4-ethylenedioxythiophene) (PEDOT), which is optionally substituted, as in poly(4-[(2,3-dihydrothieno[3,4-b]-[1,4]dioxin-2-yl)methoxy]propane-1-sulfonic acid), poly(4-[(2,3-dihydro-thieno[3,4-b][1,4]di-oxin-2-yl)methoxy]butane-1-sulfonic acid) (PEDOT-S) or poly(4-[(2,3-dihydro-thieno[3,4-b][1,4]dioxin-2-yl)methoxy]butane-2-sulfonic acid).

In the context of the invention, the prefix "*poly*" should be understood to mean that more than one identical or different repeat unit is present in the polymer or polythiophene. The polythiophenes contain a total of n repeat units of the general formula (I) or of the general formula (II) or of the general formula (III) or of the general formulae (I) and (II) or of the general formulae (I) and (III) or of the general formulae (II) and (III) or of the general formulae (I), (II) and (III), where n is an integer of 2 to 2000, preferably 2 to 100. The repeat units of the general formula (I) or of the general formula (II) or of the general formula (III) or the repeat units of the general formulae (I) and (II) or the repeat units of the general formulae (I) and (III) or the repeat units of the general formulae (II) and (III) or the repeat units of the general formulae (I), (II) and (III) may each be the same or different within a polythiophene. Preference is given to polythiophenes having in each case identical repeat units of the general formula (I) or of the general formula (II) or of the general formula (III) or having in each case identical repeat units of the general formulae (I) and or of the general formulae (I) and (III), or of the general formulae (II) and (III), or having in each case identical repeat units of the general formulae (I), (II) and (III). Particular preference is given to polythiophenes having in each case identical repeat units of the general formula (I) or of the general formula (II) or having in each case identical repeat units of the general formulae (I) and (II). At the end groups, the polythiophenes preferably each bear H.

In the context of the invention, C₁-C₅-alkylene radicals are preferably methylene, ethylene, n-propylene, n-butylene or n-pentylene. C₁-C₁₈-Alkyl R is preferably linear or branched C₁-C₁₈-alkyl radicals such as methyl, ethyl, n- or isopropyl, n-, iso-, sec- or tert-butyl, n-pentyl, 1-methylbutyl, 2-methylbutyl, 3-methylbutyl, 1-ethylpropyl, 1,1-dimethylpropyl, 1,2-dimethylpropyl, 2,2-dimethylpropyl, n-hexyl, n-heptyl, n-octyl, 2-ethylhexyl, n-nonyl, n-decyl, n-undecyl, n-dodecyl, n-tridecyl, n-tetradecyl, n-hexadecyl or n-octadecyl, C₅-C₁₂-cycloalkyl radicals R are, for example, cyclopentyl, cyclohexyl, cycloheptyl, cyclooctyl, cyclononyl or cyclodecyl, C₆-C₁₄-aryl radicals R are, for example, phenyl or naphthyl, and C₇-C₁₈-aralkyl radicals R are, for example, benzyl, o-, m-, p-tolyl, 2,3-, 2,4-, 2,5-, 2,6-, 3,4-, 3,5-xylyl or mesityl. The above list serves to illustrate the invention by way of example and should not be considered to be exclusive.

In the context of the invention, any further substituents of the A radicals and/or of the R radicals include numerous organic groups, for example alkyl, cycloalkyl, aryl, aralkyl, alkoxy, halogen, ether, thioether, disulfide, sulfoxide, sulfone, sulfonate, amino, aldehyde, keto, carboxylic ester, carboxylic acid, carbonate, carboxylate, cyano, alkylsilane and alkoxysilane groups, and also carboxamide groups.

The polythiophenes may be uncharged or cationic. In preferred embodiments, they are cationic, "*cationic*" relating only to the charges which reside on the main polythiophene chain. According to the substituent on the R radicals, the polythiophenes may bear positive and negative charges in the structural unit, in which case the positive charges are on the main polythiophene chain and the negative charges are, if present, on the R radicals substituted by sulfonate or carboxylate groups. The positive charges of the main polythiophene chain may be partly or fully saturated by the anionic groups which may be present on the R radicals. Viewed overall, the polythiophenes in these cases may be cationic, uncharged or even anionic. Nevertheless, in the context of the invention, all are considered to be cationic polythiophenes, since the positive charges on the main polythiophene chain are crucial. The positive charges are not shown in the formulae, since their exact number and position cannot be stated unambiguously. The number of positive charges is, however, at least 1 and at most n, where n is the total number of all repeat units (identical or different) within the polythiophene.

The positive charge of the polythiophenes can be balanced by sulfonate- or carboxylate-substituted and thus negatively charged R radicals (so called "self-doped polythiophenes") or by counter-ions (so called "*foreign-doped polythiophenes*")*.*

According to a first preferred embodiment of the polythiophenes in the liquid composition, the polythiophenes are self-doped polythiophenes that preferably comprise, to the extent of at least 50 %, still more preferably to the extent of at least 75 %, still more preferably to the extent of at least 95 % and most preferably to the extent of 100 %, recurring units of the formula (IV) 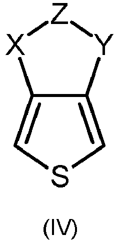 in which
- X,Y: are identical or different and denote O, S, N-R¹, wherein R¹ denotes aryl, C₁-C₁₈-alkyl or hydrogen;
- Z: is an organic group carrying an anionic functional group, preferebly a SO₃₋ group, wherein it is particualrly preferred that Z denotes -(CH₂)ₘ-CR²R³-(CH₂)ₙ-,
- R²: denotes hydrogen, -(CH₂*)ₛ-*O-(CR⁴₂)ₚ-SO₃⁻M⁺ or -(CH₂*)ₚ*-SO₃₋M⁺,
- R³: denotes -(CH₂*)ₛ*-O-(CR⁴₂)ₚ-SO₃⁻M⁺ or -(CH₂*)ₚ*-SO₃₋M⁺,
- M⁺: denotes a cation,
- m,n: are identical or different and denote an integer from 0 to 3,
- R⁴: denotes hydrogen or a C₁-C₁₀ alkyl group, preferably a methyl group,
- s: denotes an integer from 0 to 10 and
- p: denotes an integer from 1 to 18.

The percentage figures stated above are intended in this context to express the numerical content of the units of the structural formula (IV) in the total number of monomer units in the self-doped conductive polymer.

Suitable cations M⁺ are e.g. H⁺, Li⁺, Na⁺, K⁺, Rb⁺, Cs⁺ and NH₄⁺. Particularly suitable cations are Na⁺ and K⁺.

Particularly preferred monomers of the structural formula (IV) are those in which
- X,Y: denote O,
- Z: denotes -(CH₂)ₘ-CR²R³-(CH₂)ₙ-,
- R²: denotes hydrogen or -(CH₂*)ₛ*-O-(CH₂)ₚ-SO₃⁻M⁺, -(CH₂*)ₚ*-SO₃₋M⁺ or -(CH₂*)ₛ*-O-(CH₂)ₚ-CHR⁴-SO₃₋M⁺,
- R³: denotes -(CH₂*)ₛ*-O-(CH₂)ₚ-SO₃₋M⁺, -(CH₂*)ₚ-*SO₃₋M⁺ or -(CH₂*)ₛ*-O-(CH₂)ₚ-CHR⁴-SO₃₋M⁺,
- M⁺: denotes a cation,
- m,n: are identical or different and denote an integer from 0 to 3,
- R⁴: denotes hydrogen a methyl group or an ethyl group;
- s: denotes an integer from 0 to 10 and
- p: denotes an integer from 1 to 18.

Very particularly preferred monomers of the structural formula (IV) are those in which
- X,Y: denote O,
- Z: denotes -(CH₂)-CR²R³-(CH₂)ₙ-,
- R²: denotes hydrogen,
- R³: denotes -(CH₂*)ₛ*-O-(CH₂)ₚ-SO₃₋M⁺, -(CH₂*)ₚ*-SO₃₋M⁺, or -(CH₂*)ₛ*-O-(CH₂)ₚ-CH(CH₃)-SO₃₋M⁺ or -(CH₂*)ₛ*-O-(CH₂)ₚ-CH(CH₂CH₃)-SO₃₋M⁺,
- M⁺: denotes Na⁺ or K⁺,
- n: denotes 0 or 1,
- s: denotes 0 or 1 and
- p: denotes 2, 3, 4 or 5.

Suitable Examples of self-doped polymers are disclosed in WO-A-2014/048562 and in US-A-2015/0337061. Concrete examples of very particularly preferred self-doped conductive polymers include poly(4-[(2,3-dihydrothieno[3,4-b]-[1,4]dioxin-2-yl)methoxy]propane-1-sulfonic acid), poly(4-[(2,3-dihydrothieno-[3,4-b][1,4]dioxin-2-yl)methoxy]butane-1-sulfonic acid) (PEDOT-S), poly(4-[(2,3-dihydrothieno[3,4-b][1,4]dioxin-2-yl)methoxy]butane-2-sulfonic acid) or a mixture thereof.

According to a second preferred embodiment of the polythiophenes in the liquid composition, the polythiophenes are foreign-doped polythiophenes that preferably comprise polymeric counter-ions to balance the positive charges, the latter also being referred to hereinafter as "polyanions". Thus, according to a preferred embodiment of the liquid composition the polythiophene is a cationic polythiophene that comprises a polyanions serving as a counter-ion for the polythiophene.

Polyanions are preferred over monomeric anions, since they contribute to film formation and, owing to their size, lead to thermally more stable, electrically conductive films. Polyanions here may, for example, be anions of polymeric carboxylic acids, such as polyacrylic acids, polymethacrylic acid or polymaleic acids, or polymeric sulfonic acids, such as polystyrenesulfonic acids and polyvinylsulfonic acids. These polycarboxylic and -sulfonic acids may also be copolymers of vinylcarboxylic and vinylsulfonic acids with other polymerizable monomers, such as acrylic esters and styrene.

A preferred polyanion is an anion of a polymeric carboxylic or sulfonic acid. A particularly preferred polyanion is the anion of polystyrenesulfonic acid (PSS) or a derivative thereof.

The molecular weight of the polyacids which afford the polyanions is preferably 1000 to 2000000, more preferably 2000 to 500000. The polyacids or alkali metal salts thereof are commercially available, for example polystyrenesulfonic acids and polyacrylic acids, or else are preparable by known processes (see, for example, Houben Weyl, Methoden der organischen Chemie [Methods of Organic Chemistry], vol. E 20 Makromolekulare Stoffe [Macromolecular Substances], part 2, (1987), p. 1141 ff.).

A concrete example of very particularly preferred foreign-doped polythiophene is a complex of poly(3,4-ethylenedioxythiophene) and an anion of polystyrene sulfonic acid (PEDOT/PSS).

### Aromatic nitro compound

The liquid composition according to the present invention or the liquid composition used in the process according to the present invention further comprises an aromatic nitro compound **iii).**

An "*aromatic nitro compound*" can be any compound that comprises an aromatic group, such a benzyl group, a naphthyl group or an anthryl group, or a heteroaromatic group, such as a pyridine group, a pyrrole group, a thiophene group, an imidazole group or a pyrimidine group, wherein an aromatic group such a benzyl group or naphthyl group are particularly preferred, and wherein at least on hydrogen atom of the aromatic ring system is substituted by a -NO₂ group.

In this context it is particularly preferred that the aromatic nitro compound **iii)** has a dry residue, as determined by the test method disclosed herein, of at least 1 wt.-%, preferably of at least 1.5 wt.-%, more preferably of at least 2 wt.-%, even more preferably of at least 2.5 wt.-% and even more preferably of at least 3 wt.-%. Among these compounds, preference is given to aromatic nitro compounds iii) having the structural formula **(A)** 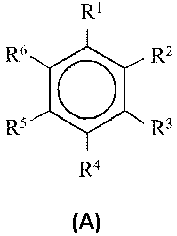 wherein at least one of residues **R¹-R⁶** is a group -NO₂. In this context each residue **R¹-R⁶** can, for example, be selected from the group consisting of -H, -CH₃, -COOH, -SO₃H, -SO₃Na, -CH₂-PO(OC₂H₅)₂, -OCH₃, -CH₂OH, -OH, -CH₂-O-COCH₃ (with the proviso at least one of residues **R¹-R⁶** is a group -NO₂). According to a particularly preferred embodiment of the aromatic nitro compound iii), at least one of residues **R¹-R⁶** is a group -NO₂ and at least one of residues **R¹-R⁶** is a group -CH₂OH. Particularly preferred aromatic nitro compounds **(III**) are selected from the group consisting of 22,4,6-Trinitrophenol, 2-(2,4-Dinitrobenzyl)pyridine, 3,5-Dinitrobenzyl alcohol, 4,5-Dimethoxy-2-nitrobenzyl alcohol, 4-Hydroxy-3-nitro-benzenemethanol, 1-(4-Nitrobenzyl)-1,2,4-triazole, 2-Hydroxy-5-nitrobenzyl alcohol, Diethyl(4-nitrobenzyl)phosphonate or a combination of at least two of these aromatic nitro compounds.

### Further additives

The liquid composition according to the present invention or of the liquid composition used in the process according to the present invention may further comprises at least one additive, wherein the at least one additive is an additive selected from the group consisting of a binder, a pH-regulator, a crosslinker, an adhesion promoter, a conductivity improver, a surfactant, a stabilizer and a combination of at least two of these additives.
- Suitable binders comprise organic binders which in particular are soluble in organic solvents, such as polyolefins, polyvinyl acetate, polycarbonate, polyvinyl butyral, polyacrylic acid esters, polyacrylic acid amides, polymethacrylic acid esters, polymethacrylic acid amides, polystyrene, polyacrylonitrile, polyvinyl chloride, polyvinyl pyrrolidones, polybutadiene, polyisoprene, polyethers, polyesters, polyurethanes, polyamides, polyimides, polysulphones, polysilicones, epoxy resins, styrene-acrylate, vinyl acetate/acrylate and ethylene/vinyl acetate copolymers, polyvinyl alcohols or cellulose derivatives, can also be added to the composition. Also suitable as binders are copolymers of the above-mentioned polymers.

- Suitable pH-regulators comprise the bases or acids that, for example, are described on page 4, lines 13-32 of WO 2010/003874 A2. Preferred are such additives that do not impair the film formation of the liquid composition and are not volatile at relatively high temperatures, for example, at soldering temperatures, but remain within the solid electrolyte under these conditions. Particularly suitable are compounds such as the bases 2-dimethyl-aminoethanol, 2,2'-iminodiethanol or 2,2',2"-nitrilotriethanol and the acid polystyrene sulfonic acid.
- Suitable crosslinkers comprise melamine compounds, capped isocyanates, functional silanes, for example tetraethoxysilane, alkoxysilane hydrolysates for example based on tetraethoxysilane, or epoxysilanes such as 3-glycidoxypropyl trialkoxysilane.
- Suitable adhesion promoters comprise organo-functional silanes or their hydrolysates, for example, 3-glycidoxy-propyltrialkoxysilane, 3-amino-propyl-triethoxysilane, 3-mercaptopropyltrimethoxysilane, 3-methacryl-oxypropyl-trimethoxysilane, vinyltrimethoxysilane or octyltriethoxysilane.
- Suitable conductivity improver comprise compounds such as for example tetrahydrofuran, lactone group-comprising compounds such as butyrolactone, valerolactone, amide group- or lactam group-comprising compounds such as caprolactam, N-methyl caprolactam, N,N-dimethyl acetamide, N-methyl acetamide, N,N-dimethyl formamide (DMF), N-methyl formamide, N-methyl formanilide, N-methyl pyrrolidone (NMP), N-octyl pyrrolidone, pyrrolidone, sulphones and sulphoxides, such as for example sulpholane (tetramethylene sulphone), dimethyl sulphoxide (DMSO), sugar or sugar derivatives, such as for example sucrose, glucose, fructose, lactose, sugar based surfactants such as Tween or Span 60, sugar alcohols such as for example sorbitol, mannitol, furan derivatives such as for example 2-furan carboxylic acid, 3-furan carboxylic acid, and/or di- or polyalcohols such as for example ethylene glycol, glycerol, di- or triethylene glycol or polyglycerols. Ethylene glycol, diethylene glycol, triethylene glycol, polyglycerols, dimethyl sulphoxide or sorbitol are particularly preferably used as conductivity-improving additives.
- Suitable surfactants include anionic surfactants, such as e.g. alkylbenzenesulphonic acids and salts, paraffin sulphonates, alcohol sulphonates, ether sulphonates, sulphosuccinates, phosphate esters, alkyl ether carboxylic acids or carboxylates, cationic surfactants, such as *e.g*. quaternary alkylammonium salts, nonionic surfactants, in particular non-ionic amphiphilic surfactants, such as e.g. linear or branched alcohol ethoxylates, oxo alcohol ethoxylates, alkylphenol ethoxylates or alkyl polyglucosides. Representative examples of suitable surfactants include fluorosurfactants such as ZONYL^{®} surfactants, including ZONYL^{®} FSN, ZONYL^{®} FSO, ZONYL^{®} FSA, ZONYL^{®} FSH (DuPont Chemicals, Wilmington, Del.), and NOVEC^{®} (3M, St. Paul, Minn.). Other exemplary surfactants include non-ionic surfactants based on alkylphenol ethoxylates. Preferred surfactants include, for example, octylphenol ethoxylates such as TRITON^{®}, and secondary alcohol ethoxylates such as TERGITOL^{®} 15-S series (Dow Chemical Company, Midland Mich.). Further exemplary non-ionic surfactants include acetylenic-based surfactants, n-dodecyl β-D-mattoside and alcohol ethoxylates such as TERGITOL^{®} TMN.
- Suitable stabilisers are those compounds which are mentioned in WO 2012/041507 A1, wherein aromatic compounds containing at least two OH groups and one further functional group with a hetero atom which differs from carbon are particularly preferred. Examples of suitable stabilizers are 3,4,5-trihydroxybenzoic acid and derivatives thereof like 3,4,5-trihydroxybenzoic acid esters (gallic acid esters), in particular alkyl esters, alkenyl esters, cycloalkyl esters, cycloalkenyl esters, aryl esters, having preferably in each case 1 to 15 C atoms in the aryl or alkyl groups of the esters, are furthermore to be mentioned. Particularly preferred are gallic acids and gallic acids esterified with sugars, which are often called tannin or gallotannins (cf. Römpp Chemie, 10th edition (1999), page 4391). Also suitable as stabilizers are the "*hydroxy-group-containing aromatic compounds*" that are mentioned in paragraph [0049] of EP 1 798 259 A1, the "*anti-oxidants*" that are mentioned in paragraph [0025] of EP 1 043 720 A1 and the "*aromatic compounds exclusive of sulfo groups and containing at least two hydroxy groups*" that are mentioned on pages 10 and 11 of WO 2008/055834 A1.

### Process for producing a capacitor

According to a preferred embodiment of the process for the preparation of a layered body according to the present invention, the layered body is part of an electrolyte capacitor. In this case, the process comprises the steps of
**A)** provision of a porous electrode body made of an electrode material, wherein a dielectric layer at least partially covers a surface of this electrode material;
**B)** introduction of a liquid composition into at least a part of the porous electrode body provided in process step **A),** wherein the liquid composition comprises
   **i)** a conductive polymer;
   **ii)** a dispersant in which the conductive polymer is dispersed;
   **iii)** an aromatic nitro compound;
   wherein the liquid composition comprises the aromatic nitro compound iii) in an amount in the range from 0.025 to 0.9 wt.-%, preferably in the range from 0.1 to 0.9 wt.-%, more preferably in the range from 0.1 to 0.8 wt.-%, even more preferably in the range from 0.1 to 0.6 wt.-%, even more preferably in the range from 0.2 to 0.5 wt.-%, even more preferably in the range from 0.2 to 0.4 wt.-%, in each case based on the weight of the liquid composition;
**C)** at least partial removal of the dispersant **ii)** for the formation of a solid electrolyte layer;
**D)** optionally application of a dispersion containing a conductive polymer, preferably a dispersion comprising a polythiophene and a dispersant, more preferably a dispersion comprising a dispersant and particles of a complex of a polythiophene and a polymeric anion, even more preferably a PEDOT/PSS-dispersion, onto at least a part of the surface of the solid electrolyte layer and at least partial removal of the dispersant for the formation of a polymeric outer layer that at least partially covers a surface of the solid electrolyte layer;
**E)** optionally filling at least a part of the pores of the porous electrode body obtained in process step **C)** or in process step **D)** (*i. e*., the porous electrode body in which the surface of the dielectric layer is at least partially covered with a solid electrolyte layer) with an impregnation solution comprising at least one impregnation solvent;
**F)** Encapsulation.

### Process step A):

In process step **A)** a porous electrode body made of an electrode material is provided, wherein a dielectric layer at least partially covers a surface of this electrode material.

In principle, the porous electrode body can be manufactured in that a valve-metal powder with a high surface area is pressed and sintered to form a porous electrode body. In this context, an electrical contact wire preferably made from a valve metal, such as tantalum, is conventionally pressed into the porous electrode body. The porous electrode body is then coated with a dielectric, that is, an oxide layer, for example, by electrochemical oxidation. As an alternative, metal films can be etched and coated with a dielectric by electrochemical oxidation in order to obtain an anode film with a porous region. In the case of a wound capacitor, an anode film with a porous region, which forms the electrode body, and a cathode film are separated by separators and wound up.

Within the scope of the invention, metals of which the oxide coatings do not allow the flow of current uniformly in both directions are understood as valve metals. With a voltage applied at the anode, the oxide layers of the valve metals block the flow of current, while in the case of a voltage applied to the cathode, considerable currents occur, which can destroy the oxide layer. The valve metals include Be, Mg, Al, Ge, Si, Sn, Sb, Bi, Ti, Zr, Hf, V, Nb, Ta and Wand an alloy or compound of at least one of these metals with other elements. The most well-known representatives of the valve metals are Al, Ta and Nb. Combinations of electrical properties comparable with a valve metal are those with metallic conductivity, which can be oxidised and of which the oxide layers provide the properties described above. For example, NbO shows metallic conductivity, but is not generally regarded as a valve metal. However, layers of oxidised NbO show the typical properties of valve-metal oxide layers, so that NbO or an alloy or compound of NbO with other elements are typical examples of such compounds with electrical properties comparable with a valve metal. Electrode materials made of tantalum, aluminium and such electrode materials which are based on niobium or niobium oxide are preferred. Aluminium and Tantalum are particularly preferred as an electrode material.

For the manufacture of the porous electrode body often with a porous region, the valve metals can be sintered, for example, in powdered form to provide a generally porous electrode body, or alternatively, a porous structure is imprinted onto a metallic body. The latter can be implemented, for example, by etching a film.

In the following, for the sake of simplicity, bodies with a porous region are also referred to as porous. For example, electrode bodies with a porous region are also referred to as porous electrode bodies. On the one hand, the porous bodies can be penetrated by a plurality of channels and therefore be sponge-like. This is often the case if tantalum is used in the construction of the capacitor. On the other hand, pores can be present only at the surface, and the region disposed below the surface pores can be formed in a solid manner. This is often observed, if aluminium is used in the capacitor construction.

The porous electrode bodies manufactured in this manner are then oxidised, for example in an appropriate electrolyte, for example, phosphoric acid or an aqueous solution of ammonium adipate, by applying a voltage, in order to form the dielectric. The magnitude of this forming voltage is dependent upon the oxide-layer thickness to be achieved or respectively the subsequent operating voltage of the capacitor. Preferred forming voltages lie in a range of from 1 to 1000 V, particularly preferably in a range of from 10 to 200 V, more particularly preferably in a range of from 15-100 V, more preferably in a range of from 20-80 V.

The porous electrode bodies used preferably have a porosity of 10 to 90 %, preferably of 30 to 80 %, particularly preferably of 50 to 80 %, and an average pore diameter of from 10 to 10000 nm, preferably from 50 to 5000 nm, particularly preferably from 100 to 3000 nm.

According to a special embodiment of the process according to the invention, the electrolytic capacitor to be manufactured is an aluminium wound capacitor. In this case, in process step **A),** a porous aluminium film as electrode material is formed anodically, whereby an aluminium-oxide coating is formed as the dielectric. The aluminium film (anode film) thus obtained is then provided with a contact wire and wound up with a further porous aluminium film (cathode film) also provided with a contact wire, whereby these two films are separated from one another by one or more separator papers, which are based, for example, on cellulose or preferably on synthetic papers. After the winding, the anode bodies obtained in this manner are fixed, for example, by means of an adhesive tape. The separator paper or papers can be carbonised by heating in an oven. This manner of manufacturing anode bodies for aluminium wound capacitors is sufficiently known from the prior art and is described, for example in US 7,497,879 B2.

Process steps **B)** and **C):**

In process step **B)** of the process according to the invention, a liquid dispersion comprising components **i), ii)** and **iii)** (or a liquid composition according to the present invention) is introduced into at least a part of the porous electrode body provided in process step **A).** In process step **C)** the dispersant **ii)** is then at least partially removed for the formation of a solid electrolyte layer that either at least partially covers directly or indirectly (indirectly, if intermediate layers are provided between the solid electrolyte layer and the dielectric layer) a surface of the dielectric layer.

The liquid composition is introduced into the porous region using known processes, for example, immersion, dipping, pouring, dripping, injection, spraying, spreading, painting or printing, for example, ink-jet printing, screen printing or tampon printing. The introduction is preferably carried out in that the porous electrode body provided in process step **A)** is immersed in the liquid composition and is accordingly impregnated with this liquid composition. The immersion into or the impregnation with the liquid composition is preferably implemented for a duration in a range of from 1 second to 120 min, particularly preferably in a range of from 10 seconds to 60 min and most preferably in a range of from 30 seconds to 15 min. The introduction of the liquid composition into the anode body can be facilitated, for example, by increased or reduced pressure, vibration, ultrasound or heat.

After the porous electrode bodies have been impregnated with the liquid composition as described above, the dispersant **ii)** is at least partially removed in process step **C),** so that a solid electrolyte layer is formed. In this context, it is preferable that the covering of the dielectric by the solid electrolyte layer preferably amounts to at least 50 %, particularly preferably at least 70 % and most preferably at least 80 %, wherein the measurement of the capacitance of the capacitor in a dry and wet condition at 120°C allows a determination as described in DE-A-10 2005 043 828.

The removal of the dispersant **ii)** is preferably carried out in that the porous electrode body is removed from the dispersion used in process step B**)** and is subsequently dried, wherein the drying preferably takes place at a temperature in a range from 20°C to 200°C, particularly preferably in a range from 50°C to 180°C and more preferably in a range from 80°C to 150°C. The drying conditions (*i. e*. drying time, drying pressure and drying temperature) are preferably adjusted to be within a range that ensures that at least 50 wt.-%, more preferably at least 75 wt.-%, even more preferably at least 90 wt.-%, even more preferably at least 95 wt.-% and most preferably at least 99 wt.-% of the total amount of the dispersant ii) is removed when forming the solid electrolyte layer. In a particularly preferred embodiment of the process according to the present invention the drying conditions are adjusted to be within a range that ensures that the dispersant **i)** is completely removed when forming the solid electrolyte layer.

### Process step D):

In process step **D)** a dispersion containing a conductive polymer, preferably a dispersion comprising a polythiophene and a dispersant, more preferably a dispersion comprising a dispersant and particles of a complex of a polythiophene and a polymeric anion, even more preferably a PEDOT/PSS-dispersion, may be applied onto at least a part of the surface of the solid electrolyte layer, followed by an at least partial removal of the dispersant for the formation of a polymeric outer layer that at least partially covers the surface of the solid electrolyte layer (as disclosed, for example, in DE 10 2004 022 674 A1). The term "*polymeric outer*" layer as used herein preferably refers to an outer layer that, although it may comprise the very same conductive polymer as the solid electrolyte layer, nevertheless differs from the solid electrolyte layer with respect to, for example, the chemical composition, the conductivity and/or a property such as the hardness, the surface roughness, the adhesion property *etc..* The polymeric outer layer, usually having a thickness in the range from 5 to 50 µm, serves as a mechanical buffer between the capacitor anode and the cathode-side contact, preventing the cathode-side-contact to come into contact with the dielectric under mechanical stresses that may occur during the manufacture of the capacitor.

Before applying a dispersion containing a conductive polymer onto at least a part of the surface of the solid electrolyte layer in process step **D),** it may also be advantageous to apply a crosslinker onto at least a part of the surface of the solid electrolyte layer in order to improve the coverage of the capacitor anode by the polymeric outer layer. Suitable crosslinkers and processes for their application are, for example, disclosed in DE 10 2009 007 594 A1.

### Process step E):

In process step **E)** of the process according to the invention at least a part of the pores of the porous electrode body obtained in process step **C)** (*i. e*., the porous electrode body in which the dielectric layer is at least partially covered with a solid electrolyte layer) can be filled with an impregnation solution comprising at least one impregnation solvent.

The immersion in or respectively the impregnation with the impregnation solution is preferably implemented for a duration in a range of from 1 second to 120 min, particularly preferably in a range of from 10 seconds to 60 min and most preferably in a range of from 30 seconds to 15 min. The immersion is preferably carried out in that the porous electrode body obtained in process step C) is immersed at least partially in the impregnation solution or the impregnation solution is injected into the porous electrode body and is accordingly impregnated with this impregnation solution. The introduction of the impregnation solution into the porous electrode body can be facilitated, for example, by increased or reduced pressure, vibration, ultrasound or heat.

In process step **E)** it is particularly preferred that the impregnation solution is applied immediately before performing process step **F)** described below, *i. e*. before encapsulating the porous electrode body in order to prevent evaporation of the impregnation solvent out of the pores. The impregnation solution applied in process step **E)** thus remains - at least to a certain extent, preferably completely - within the pores of the porous electrode body before it is encapsulated.

Examples of the impregnation solvent include a sulfone compound, a lactone compound, a carbonate compound, and a polyhydric alcohol. The impregnation solvent may be used singly or in combination of two or more kinds thereof.

Examples of the sulfone compound include sulfolane, dimethyl sulfoxide, and diethyl sulfoxide. Examples of the lactone compound include γ-butyrolactone and γ-valerolactone. Examples of the carbonate compound include dimethyl carbonate, diethyl carbonate, ethyl methyl carbonate, ethylene carbonate, propylene carbonate, and fluoroethylene carbonate. Examples of the polyhydric alcohol include a glycerin compound, a sugar alcohol compound, and a glycol compound. Examples of the glycerin compound include glycerin, polyglycerin (diglycerin, triglycerin, etc.), and derivatives thereof. Examples of the glycol compound include an alkylene glycol (C2-4 alkylene glycol (ethylene glycol, propylene glycol, etc.), and the like), a polyalkylene glycol (poly C2-4 alkylene glycol (diethylene glycol, dipropylene glycol, triethylene glycol, polyethylene glycol, etc.), and the like).

The impregnation solution may include a solute. Examples of the solute include an acid component, such as carboxylic acids, sulfur-containing acids, boron-containing acids and phosphorus-containing acids, and a base component, such as ammonia, amine, a quaternary ammonium compound and an amidinium compound.

The liquid component may include the acid component and the base component in a free state or in a salt form, respectively. The liquid component may include an organic salt. Examples of the organic salt include those in which at least one of the acid component and the base component is organic.

The concentration of the solute in the liquid component is, for example, in a range from 0.1 to 25 wt.-%, inclusive, and may be in a range from 0.5 to 15 wt.-%, inclusive.

Encapsulation in process step **F):**
After in process step **C)** at least a part of the dispersant **ii)** has been removed or - if process step **D)** and/or process step **E)** are performed - after in process step **D)** a polymeric outer layer has been applied or after in process step **E)** at least a part of the pores of the porous electrode body obtained in process step **C)** has been filled with an impregnation solution, the electrolytic capacitors can be finished, particularly encapsulated, in a manner known to the person skilled in the art. In the case of a tantalum electrolytic capacitor, the capacitor body can be coated, for example, with a graphite layer and a silver layer, as known from DE-A-10 2005 043 828, while in the case of an aluminium wound capacitor corresponding to the teaching of US 7,497,879 B2, the capacitor body is built into an aluminium cup, provided with a sealing rubber and firmly closed in a mechanical manner by flanging.

Encapsulation is preferably accomplished by sealing the capacitor body with resins, such as epoxy resins or thermoplastic resins like those disclosed in EP 0 447 165 A2. In case of an aluminium electrolytic capacitor encapsulation is preferably accomplished by providing the porous electrode body obtained in process step e) with the aluminium cup and closing it with the sealing rubber.

The features disclosed in the claims, the specification, and the drawings maybe essential for different embodiments of the claimed invention, both separately and in any combination with each other.

### DESCRIPTION OF THE DRAWINGS

The following schematic drawings show aspects of the invention for improving the understanding of the invention in connection with some exemplary illustrations.

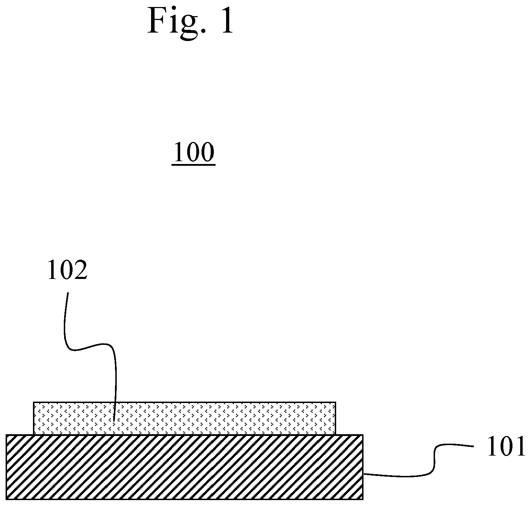

Figure 1 shows the structure of a layer body 100 prepared by the process for the preparation of a layered structure according to the invention, for example an antistatic film, in general form. On the substrate surface of a substrate 101, in the case of an antistatic film often a PE, PP or PET layer, is an electrically conductive layer 102 that has been prepared with the composition according to the invention.

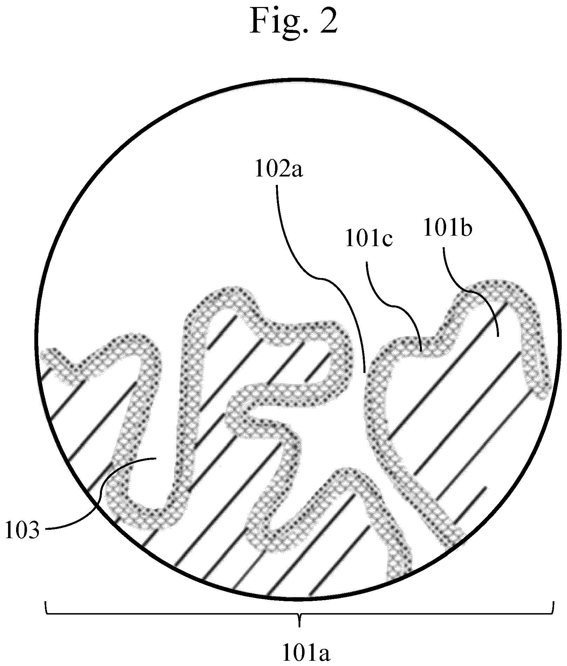

Fig. 2 shows a schematic sectional view through a part of a capacitor obtained by a particular embodiment of the process for the preparation of a layered structure according to the invention. The capacitor comprises a porous electrode body 101a comprising pores 103, made mostly from a porous electrode material 101b such as aluminium. On the surface of the electrode material 101b, a dielectric layer 101c is formed as a thin layer, so that an anode body is formed which is still porous, comprising the electrode body 101a made of the electrode material 101b and the dielectric layer 101c. On the dielectric layer 101c, there follows, optionally after further layers, a layer of a solid electrolyte layer 102a (that has been prepared using the dispersion according to the present invention), so that a capacitor body is formed, comprising the electrode body 101a made of the electrode material 101b, the dielectric layer 101c and the solid electrolyte layer 102a.

### MEASUREMENT METHODS:

### Accelerated voltage endurance test

A voltage higher than the rated voltage and close to the break-down voltage is applied for 4 hours to the capacitor.

### Dissipation Factor (DF)

The dissipation factor was determined at 20°C at 120 Hz by means of an LCR meter (Agilent 4284A). In each capacitor experiment 3 capacitors have been prepared and the average DF-value was determined.

### Equivalent series resistance (ESR)

The equivalent series resistance (in mΩ) was determined at 20°C at 100 kHz by means of an LCR meter (Agilent 4284A). In each capacitor experiment 3 capacitors have been prepared and the average ESR-value was determined.

### Solids content

In order to determine the solids content, 5 g of the of the liquid composition used in process step b) were dried for 15 h at 100°C, and the solids content was determined by differential weighing.

### pH-value

The pH-value is determined with a pH meter. After calibration the pH electrode is put into the slowly stirred dispersion or solution until the reading of the pH is constant.

### Dry-residue

A 5 wt.-% solution of the aromatic nitro compound **iii)** in dimethyl sulfoxide was prepared. 2 g of this solution was dried for 90 min at 130°C on a Halogen heater (HB43, Mettler Toledo). Afterwards the weight percentage of the dried solution to the initial weight was determined.

### EXAMPLES

### Process Step A):

A porous electrode body for a cylindrical aluminum capacitor (as described in Fig. 2) having a rated voltage of 16 V and a rated capacitance of 100 µF was produced in the following way.

An aluminum foil was etched, thereby to roughen the surface of the aluminum foil. The aluminum foil was then subjected to anodic oxidation using an aqueous ammonium adipate solution, thereby to form a dielectric layer on the surface of the aluminum foil. Thus, an anode foil was produced.

A second aluminum foil was etched, thereby to roughen the surface of the aluminum foil. Thus, a cathode foil was thus prepared.

An anode lead wire and a cathode lead wire were connected to the anode and the cathode foil, respectively. The anode and the cathode foil were wound together with two separator papers between both foils. A tape was put on the outside of the wound element to avoid unwinding of the foils. The wound element was then subjected to another anodic oxidation to form a dielectric layer on the cut edges of the anode foil.

Thus, an anode body comprising an electrode body having a dielectric layer was prepared.

### Process step B):

The porous electrode body from process step a) was placed into a chamber with a bath of a liquid composition comprising an electrically conductive polymer. Air pressure in the chamber was reduced to 100 hPa. The anode body was dipped into the liquid composition for 300 s. Then, the anode body was extracted from the liquid composition and the chamber was vented to atmospheric pressure.

### Process step C):

The anode body was dried at 120°C for 30 min and then at 150°C for 30 min.

Process step **B)** and **C)** were carried out a further time. Thus, a capacitor body was obtained.

### Process step F):

The capacitor body of process step C) was placed in a cylindrical aluminum housing and sealed with a rubber sealing, to obtain a finished capacitor.

### Synthesis Example 1 (synthesis of a conductive polymer dispersion)

868 g of deionized water and 330 g of an aqueous polystyrene sulphonic acid solution having an average molecular weight of 70000 g/mol and a solids content of 3.8 wt.-% were initially introduced into a 2 I three-necked flask with a stirrer and internal thermometer. The reaction temperature was kept between 20 and 25°C. 5.1 g of 3,4-ethylenedioxythiophene were added, while stirring. The solution was stirred for 30 min. 0.03 g of iron(III) sulphate and 9.5 g of sodium persulphate were then added and the solution was stirred for a further 24 h. After the reaction had ended, for removal of inorganic salts 100 ml of a strongly acid cation exchanger and 250 ml of a weakly basic anion exchanger were added and the solution was stirred for a further 2 h. The ion exchanger was filtered off. The poly(3,4-ethylenedioxy-thiophene)/polystyrene sulphonate dispersion was homogenized with a high pressure homogenizer ten times under a pressure of 700 bar. The dispersion was subsequently concentrated to a solids content of 2.5 % and then additionally homogenized another three times under a pressure of 1500 bar.

### Preparation Example 1

10 g of the conductive polymer from Synthesis Example 1 and 1 g of ethylene glycol were mixed and the pH was adjusted to 3.0 using ammonia. Thus, a liquid composition which comprises an electrically conductive polymer was obtained.

### Preparation Example 2

10 g of the conductive polymer from Synthesis Example 1 and 1 g of ethylene glycol were mixed and the pH was adjusted to 3.0 using ammonia. As nitroaromatic compound 4-Nitrobenzyl alcohol was mixed into this composition in an amount of 0.01 wt.-%, based on the weight of the liquid composition. Thus, a liquid composition which comprises an electrically conductive polymer was obtained.

### Preparation Examples 3-25:

Liquid compositions which comprise an electrically conductive polymer were obtained in the same way as in Preparation Example 2, except that the liquid compositions comprised as aromatic nitro compounds **iii)** the compounds in Table 1 in an amount indicated in that table.

### Example 1:

Capacitors were produced the following way:
First anode bodies according to process step **A)** were prepared. Then, the anode bodies were processed according to process step **B)** and **C)** using the liquid composition which comprises an electrically conductive polymer of Preparation Example 1. Process step **B)** and **C)** were carried out a further time. Thus, a capacitor body was obtained. Finally, the capacitor bodies were encapsulated according to process step **F)** and capacitors were obtained.

A voltage ramp of 1V/s was applied to one capacitor to determine the break-down voltage for this capacitor design. A break-down voltage of 29 V was observed.

An accelerated voltage endurance test was done for three capacitors at 28 V. The dissipation factor (DF) and ESR were measured before and after the accelerated voltage endurance test. The ratio of the value after test to the value before test for DF (Δ DF) and ESR (Δ ESR) is given in Table 1.

### Example 2-28:

Capacitors were produced the same way as in Example 1, however, instead of Preparation Example 1 the liquid compositions of Preparation Example 2-28 which comprise an electrically conductive polymer in process step **B)** were used.

An accelerated voltage endurance test was done for three capacitors at 28 V. The dissipation factor (DF) and ESR were measured before and after the accelerated voltage endurance test. The ratio of the value after test to the value before test for DF (Δ DF) and ESR (Δ ESR) is given in Table 1.

**Table 1**

| Preparation Example | Example | compound **iii)** | amount compound **iii)** [wt.-%] | Δ DF [%] | Δ ESR [%] |
|---|---|---|---|---|---|
| 1 | 1 | None | | 38.0 | 60.0 |
| 2 | 2 | 4-Nitrobenzyl alcohol | 0.01 | 31.1 | 49.5 |
| 3 | 3 | 4-Nitrobenzyl alcohol | 0.025 | 19.0 | 23.1 |
| 4 | 4 | 4-Nitrobenzyl alcohol | 0.05 | 15.3 | 12.4 |
| 5 | 5 | 4-Nitrobenzyl alcohol | 0.1 | 7.7 | 3.8 |
| 6 | 6 | 4-Nitrobenzyl alcohol | 0.3 | 2.9 | 1.5 |
| 7 | 7 | 4-Nitrobenzyl alcohol | 0.5 | 3.0 | 1.7 |
| 8 | 8 | 4-Nitrobenzyl alcohol | 0.7 | 3.7 | 1.8 |
| 9 | 9 | 4-Nitrobenzyl alcohol | 0.9 | 8.0 | 7.2 |
| 10 | 10 | 4-Nitrobenzyl alcohol | 1.0 | 37.7 | 32.6 |
| 11 | 11 | 2,4,6-Trinitrophenol | 0.2 | 1.0 | 1.2 |
| 12 | 12 | 2-(2,4-Dinitrobenzyl)pyridine | 0.5 | 1.3 | 1.3 |
| 13 | 13 | 3,5-Dinitrobenzyl alcohol | 0.2 | 1.3 | 1.3 |
| 14 | 14 | 2-Hydroxy-5-nitropyridin | 0.4 | 2.9 | 1.5 |
| 15 | 15 | 4-Methyl-3-nitrobenzyl Alcohol | 0.5 | 2.9 | 1.6 |
| 16 | 16 | 3-Methyl-4-nitrobenzyl Alcohol | 0.5 | 2.6 | 1.4 |
| 17 | 17 | 2-Hydroxy-5-nitrobenzyl Alcohol | 0.3 | 1.3 | 1.4 |
| 18 | 18 | 4,5-Dimethoxy-2-nitrobenzyl Alcohol | 0.2 | 1.3 | 1.2 |
| 19 | 19 | 3-Nitrophthalic Acid | 0.4 | 1.8 | 1.6 |
| 20 | 20 | m-Nitrobenzenesulfonic Acid Sodium Salt | 0.4 | 2.1 | 1.8 |
| 21 | 21 | Nitroterephthalic Acid | 0.4 | 1.8 | 1.9 |
| 22 | 22 | 2-Methyl-3-nitrobenzenemethanol | 0.5 | 3.1 | 1.9 |
| 23 | 23 | 3-Methyl-2-nitrobenzenemethanol | 0.5 | 2.9 | 1.6 |
| 24 | 24 | 4-Hydroxy-3-nitrobenzenemethanol | 0.3 | 1.3 | 1.2 |
| 25 | 25 | 4-Nitrobenzyl Acetate | 0.3 | 5.4 | 14.4 |
| 26 | 26 | 4-(4-Nitrobenzyl)pyridine | 0.3 | 1.4 | 1.6 |
| 27 | 27 | 1-(4-Nitrobenzyl)-1,2,4-triazole | 0.3 | 1.8 | 1.6 |
| 28 | 28 | Diethyl(4-Nitrobenzyl)phosphonate | 0.3 | 2.0 | 1.6 |

### Examples 29-41

The dry-residue of nitroaromatic compounds listed in Table 2 were determined.

**Table 2**

| Example | Compound **iii)** | dry residue [wt.-%] |
|---|---|---|
| 29 | 4-Nitrobenzyl alcohol | 0 |
| 30 | 3,5-Dinitrobenzyl alcohol | 3.5 |
| 31 | 4-Methyl-3-nitrobenzyl alcohol | 0 |
| 32 | 3-Methyl-4-nitrobenzyl alcohol | 0 |
| 33 | 2-Hydroxy-5-nitrobenzyl Alcohol | 3.9 |
| 34 | 4,5-Dimethoxy-2-nitrobenzyl alcohol | 3.7 |
| 35 | 2-Methyl-3-nitrobenzenemethanol | 0 |
| 36 | 3-Methyl-2-nitrobenzenemethanol | 0 |
| 37 | 4-Hydroxy-3-nitrobenzenemethanol | 3.5 |
| 38 | 4-Nitrobenzyl acetate | 0 |
| 39 | 4-(4-Nitrobenzyl)pyridine | 3.8 |
| 40 | 1-(4-Nitrobenzyl)-1,2,4-triazole | 2.7 |
| 41 | Diethyl (4-Nitrobenzyl)phosphonate | 1.9 |

### Example 42

### Process step A):

Tantalum powder having a specific capacitance of 50,000 CV/g was pressed to pellets with inclusion of a tantalum wire and sintered in order to form a porous electrode body having dimensions of 1.5 mm × 2.9 mm × 4.0 mm. The porous electrode bodies were anodized in a phosphoric acid electrolyte at 30 V to form a dielectric, in order to obtain capacitor bodies.

### Process steps B) and C):

The capacitor bodies obtained in process step **A)** were dipped into 10 g of a 2.5% solution of the self-doped polymer poly(4-(2,3-dihydrothieno-[3,4-b][1,4]dioxin-2-ylmethoxy)-1-butanesulphonic acid). Thereafter, drying was carried out at 120 °C for 10 min for preparing a PEDOT-S intermediate layer.

Subsequently, the capacitor bodies of were impregnated with the solution of Preparation Example 1 for 1 min. Thereafter, drying was carried out at 120 °C for 10 min. The impregnation and drying were carried out four further times to obtain a solid electrolyte layer.

### Process step D):

Subsequently, the capacitor bodies were impregnated in a crosslinker agent solution containing diaminodecane toluenesufonate salt dissolved in a water-ethanol mixture. Thereafter, drying was carried out at 120 °C for 10 min. Subsequently, the capacitor bodies were impregnated with an aqueous poly(3,4-ethylenedioxy-thiophene)/polystyrene sulphonate solution (Clevios K V2 HV, Heraeus Epurio). Thereafter, drying was carried out at 120 °C for 10 min. Impregnation and drying of crosslinker agent solution and application and drying of Clevios K V2 HV were repeated one additional time.

### Process step F):

The capacitor bodies of process were then covered with a graphite layer and thereafter with a silver layer in order to obtain the finished capacitors in this way.

An accelerated voltage endurance test was done for three capacitors at 28 V. The dissipation factor (DF) and ESR were measured before and after the accelerated voltage endurance test. The ratio of the value after test to the value before test for DF (Δ DF) and ESR (Δ ESR) is given in Table 3.

### Examples 43-49:

Capacitors were prepared as in Examples 42, however nitroaromatic compounds were mixed into the solutions in the different process steps in an amount according to Table 3, based on the weight of the solutions.

**Table 3: addition of nitroaromatic compounds in different process steps**

| Preparation Example | to PEDOT-S solution in process step **B)** | to PEDOT/PSS-dispersion in process step **B)** | to PEDOT/PSS-dispersion in process step **D)** | Δ DF [%] | Δ ESR [%] |
|---|---|---|---|---|---|
| 42 | 0 wt.-% | 0 wt.-% | 0 wt.-% | 5.2 | 3.7 |
| 43 | 4-Nitrobenzyl Alcohol (0.5 wt.-%) | 4-Nitrobenzyl Alcohol (0.5 wt.-%) | 4-Nitrobenzyl Alcohol (0.5 wt.-%) | 2.7 | 2.5 |
| 44 | 2,4,6-Trinitrophenol (0.3 wt.-%) | 0 wt.-% | 0 wt.-% | 1.5 | 1.3 |
| 45 | 0 wt.-% | 2,4,6-Trinitrophenol (0.3 wt.-%) | 0 wt.-% | 1.2 | 1.2 |
| 46 | 0 wt.-% | 0 wt.-% | 2,4,6-Trinitrophenol (0.5 wt.-%) | 2.8 | 2.4 |
| 49 | 2,4,6-Trinitrophenol (0.3 wt.-%) | 2,4,6-Trinitrophenol (0.3 wt.-%) | 0 wt.-% | 1.1 | 1.1 |
| 48 | 2,4,6-Trinitrophenol (0.3 wt.-%) | 4-Nitrobenzyl Alcohol (0.5 wt.-%) | 0 wt.-% | 1.3 | 1.1 |
| 49 | 4-Nitrobenzyl Alcohol (0.5 wt.-%) | 0 wt.-% | 2,4,6-Trinitrophenol (0.5 wt.-%) | 2.0 | 2.1 |

### KEY TO REFERENCE NUMBERS

- 100: layered body
- 101: substrate

- 101a: porous electrode body
- 101b: electrode material
- 101c: dielectric layer

- 102: electrically conductive layer

- 102a: solid electrolyte layer

- 103: pores

## Claims

1. A process for the preparation of a layered body (100), comprising the process steps:
**A)** provision of a substrate (101);
**B)** application of a liquid composition onto at least a part of a surface of this substrate (101), wherein the liquid composition comprises
**i)** a conductive polymer;
**ii)** a dispersant in which the conductive polymer is dispersed;
**iii)** an aromatic nitro compound;
wherein the liquid composition comprises the aromatic nitro compound iii) in an amount in the range from 0.025 to 0.9 wt.-%, based on the weight of the liquid composition;
**C)** at least partial removal of the dispersant **ii)** to obtain a layered body (100) comprising an electrically conductive layer (102) coated onto at least a part of the surface of the substrate (101).

2. The process according to claim 1, wherein the electrically conductive layer (102) comprises the aromatic nitro compound **iii)** in an amount in the range from 5 to 80 wt.-%, based on the total weight of the electrically conductive layer (102).

3. The process according to claim 1 or 2, wherein the layered body (100) is part of an electrolyte capacitor, wherein the substrate (101) is a porous electrode body (101a) made of an electrode material (101b), wherein a dielectric layer (101c) at least partially covers a surface of this electrode material (101b) and wherein the electrically conductive layer (102) is a solid electrolyte layer (102a), the dielectric layer (101c) being arranged between the electrode material (101b) and the solid electrolyte layer (102a).

4. The process according to claim 3, wherein the process comprises the steps of:
**A)** provision of a porous electrode body (101a) made of an electrode material (101b), wherein a dielectric layer (101c) at least partially covers a surface of this electrode material (101b);
**B)** introduction of the liquid composition into at least a part of the porous electrode body (101a) provided in process step **A);**
**C)** at least partial removal of the dispersant **ii)** for the formation of a solid electrolyte layer (102a).

5. The process according to any of claims 1 to 4, wherein the conductive polymer **i)** comprises a polythiophene.

6. The process according to claim 5, wherein the polythiophene is a foreign-doped polythiophene that is present in the form of particles of a complex comprising the polythiophene and a polyanion.

7. The process according to claim 6, wherein the weight ratio aromatic nitro compound iii) to the total weight of polythiophene and a polyanion in the electrically conductive layer (102) is in the range from 0.1 to 0.5.

8. The process according to claim 5, wherein the conductive polymer **i)** comprises a self-doped polythiophene.

9. The process according to any of claims 1 to 8, wherein the aromatic nitro compound **iii)** has the structural formula **(A)** 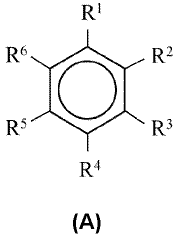 wherein at least one of residues **R¹-R⁶** is a group -NO₂.

10. The process according to claim 9, wherein at least one of residues **R¹-R⁶** is a group -NO₂ and wherein at least one of residues **R¹-R⁶** is a group -CH₂OH.

11. A layered body (100) comprising a substrate (101) and an electrically conductive layer (102) coated onto at least a part of a surface of the substrate (101), wherein the electrically conductive layer (102) comprises
**i)** a conductive polymer;
**iii)** an aromatic nitro compound;
wherein the electrically conductive layer (102) comprises the aromatic nitro compound iii) in an amount in the range from 5 to 80 wt.-%, based on the weight of the electrically conductive layer (102).

12. The layered body (100) according to claim 11, wherein
- the layered body (100) is as defined in claims 3 or 4;
- the conductive polymer **i)** is as defined in any of claims 5 to 8;
- the aromatic nitro compound **iii)** is as defined in claims 9 or 10.

13. An electronic device comprising a layered body (100) according to claims 11 or 12.

14. A liquid composition comprising
**i)** a conductive polymer;
**ii)** a dispersant in which the conductive polymer is dispersed;
**iii)** an aromatic nitro compound;
wherein the liquid composition comprises the aromatic nitro compound iii) in an amount in the range from 0.025 to 0.9 wt.-%, based on the weight of the liquid composition.

15. The liquid composition according to claim 14, wherein
- the conductive polymer **i)** is as defined in claims 5, 6 or 8;
- the aromatic nitro compound **iii)** is as defined in claims 9 or 10.
